(19) Europäisches Patentamt
European Patent Office
Office européen des brevets

(11) **EP 4 162 571 B1**

(12) **EUROPEAN PATENT SPECIFICATION**

(45) Date of publication and mention
of the grant of the patent:
**27.03.2024 Bulletin 2024/13**

(21) Application number: **21735536.1**

(22) Date of filing: **02.06.2021**

(51) International Patent Classification (IPC):
*H01S 3/08* (2023.01)  *H01S 3/00* (2006.01)
*H01S 3/101* (2006.01)  *H01S 3/105* (2006.01)
*H01S 3/107* (2006.01)  *H01S 3/137* (2006.01)
*H01S 3/139* (2006.01)  *H01S 5/14* (2006.01)

(52) Cooperative Patent Classification (CPC):
**H01S 5/143; H01S 3/08031; H01S 3/105;**
H01S 3/0014; H01S 3/08009; H01S 3/101;
H01S 3/137; H01S 3/139

(86) International application number:
**PCT/US2021/035547**

(87) International publication number:
**WO 2021/247773 (09.12.2021 Gazette 2021/49)**

(54) **TUNABLE TRANSMISSION-GRATING LASER WITH FEEDBACK**

ABSTIMMBARER ÜBERTRAGUNGSGITTERLASER MIT RÜCKKOPPLUNG

LASER À RÉSEAU DE TRANSMISSION ACCORDABLE AVEC RÉTROACTION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **03.06.2020 US 202063034268 P**

(43) Date of publication of application:
**12.04.2023 Bulletin 2023/15**

(73) Proprietor: **Intuitive Surgical Operations, Inc.
Sunnyvale, CA 94086 (US)**

(72) Inventors:
• **FROGGATT, Mark E.
Sunnyvale, California 94086 (US)**
• **CHILDERS, Brooks
Sunnyvale, California 94086 (US)**
• **MARSDEN, Kevin M.
Sunnyvale, California 94086 (US)**
• **SANBORN, Eric E.
Sunnyvale, California 94086 (US)**

(74) Representative: **MacDougall, Alan John Shaw et al
Mathys & Squire
The Shard
32 London Bridge Street
London SE1 9SG (GB)**

(56) References cited:
**EP-A1- 2 838 169**    **US-A1- 2003 063 633**
**US-A1- 2009 185 586**    **US-A1- 2018 109 069**

## Description

BACKGROUND

Many optical sensing and imaging techniques, including, for instance, Optical Frequency Domain Reflectometry (OFDR), gas absorption line detection, and Optical Coherence Tomography (OCT), use high-speed laser wavelength sweeps. There are generally two conditions that determine the lasing wavelength of a laser. The first condition, also known as the phase matching condition through the laser cavity, is that one round trip of the light through the cavity accumulates $2\pi \cdot N$ radians, where N is an integer. Different values of N correspond to different cavity modes, which represent the possible resonant frequencies of the cavity. The second condition is that the loss through the cavity is less than the gain, or, put differently, that the transmission efficiency in the cavity is greater than zero. The range of wavelengths over which this condition is satisfied, as reflected in the wavelength-dependent transmission efficiency, can be controlled by design to limit the number of cavity modes that can exist in the cavity. The wavelength-dependent transmission efficiency thus serves as a mode-selective spectral filter. In a tunable laser as used for wavelength sweeps, the wavelength locations of the cavity modes and of the spectral filter are generally controllable independently from each other. It is desirable to maintain a certain alignment between the lasing cavity mode and the filter spectrum during the course of such tuning. Otherwise, if the selected cavity mode shifts relative to the filter, mode hopping-that is, a sudden wavelength jump from one cavity mode to another-can occur. In laser wavelength sweeps, such mode hopping is generally undesirable. Accordingly, methods for aligning cavity mode and filter spectrum of a laser, to avoid or at least reduce mode hopping, are needed.

US 2009/185586 A1 discloses a wavelength tuning apparatus and method that maintain efficiency with a single angle manipulation without changing a position of input/output light. For this, the wavelength tuning apparatus and method include a transmission-type diffraction grating and a mirror that are constructed in one-body type so that a light path that enables an efficient diffraction angle of the diffraction grating can be formed, and rotates the one-body construction to obtain a desired wavelength.

BRIEF DESCRIPTION OF THE DRAWINGS

This disclosure provides a tunable transmission-grating laser with signed proportional feedback that facilitates aligning the cavity modes with the filter spectrum of the laser. Various embodiments are described with reference to the accompanying drawings, in which:

FIG. 1 is a schematic top view of a basic configuration of an example tunable laser with a controllable mirror and a transmission grating in accordance with various embodiments;

FIGS. 2A and 2B schematically show a spectrum of laser cavity modes and a grating filter spectrum, respectively, for the laser of FIG. 1;

FIGS. 3A and 3B show, in top views, different relative orientations between a controllable laser and a transmission grating of the laser of FIG. 1, illustrating tuning of the grating filter spectrum in accordance with various embodiments;

FIGS. 4A and 4B are schematic top views of the tunable laser of FIG. 1, illustrating ways of shifting the cavity modes of the laser without changing the filter spectrum, in accordance with various embodiments, and FIG. 4C illustrates the spectral shifting of the cavity modes in a schematic depiction of the spectrum of the cavity modes relative to the filter spectrum;

FIGS. 5A and 5B schematically show the laser cavity modes of FIG. 2A relative to the grating filter spectrum of FIG. 2B in unaligned and aligned states, respectively;

FIG. 6 is a schematic top view of an example tunable laser with a transmission grating and a mirror movable about a remote pivot point to facilitate mode-hop-free tuning, in accordance with one embodiment;

FIG. 7A is a schematic top view of the tunable laser of FIG. 1 illustrating an off-center cavity mode, as may be indirectly monitored for alignment in accordance with various embodiments, and FIG. 7B illustrates the off-center cavity mode relative to the filter spectrum of the laser;

FIG. 8 is a schematic side view of the tunable laser of FIG. 1, illustrating the tilt angle of the controllable mirror, as may be adjusted in accordance with various embodiments;

FIG. 9 is a schematic block diagram of a tunable transmission-grating laser system with feedback control, in accordance with various embodiments;

FIG. 10 is a schematic top view of a portion of the tunable transmission-grating laser system with feedback control, including the tunable laser of FIG. 1 along with a second transmission grating to create a monitoring beam, in accordance with various embodiments;

FIG. 11A is a schematic front view of a quadrant detector for measuring a monitoring beam spot, in accordance with various embodiments, and FIG. 11B shows, in side view, the corresponding position of the intracavity beam spot relative to the gain medium of the laser;

FIG. 12 is a schematic top view of a portion of a tunable transmission-grating laser system with feedback control that utilizes a position-sensitive diode to measure the location of the monitoring beam, in accordance with one embodiment;

FIG. 13 is a schematic top view of a portion of a tunable transmission-grating laser system with feedback control that utilizes an imaging array to measure the location of the monitoring beam, in accordance with one embodiment;

FIG. 14 is a schematic top view of a portion of a tunable transmission-grating laser system with feedback control that is configured to scan the monitoring beam across a receiver, in accordance with one embodiments;

FIG. 15A is a schematic top view of a portion of a tunable transmission-grating laser system with feedback control that is configured to measure the location of the monitoring beam with a small-area movable receiver, in accordance with one embodiment, and FIG. 15B is a front view of an example fiber-based receiver as may be used in this embodiment; and

FIG. 16 is a flowchart of a method of aligning, in a tunable laser, the intracavity beam with the gain medium, in accordance with various embodiments.

FIG. 17 is a flowchart of a method of mode-hop-free laser tuning, in accordance with various embodiments.

DESCRIPTION

Described herein is a tunable laser that uses a controllable resonator mirror in conjunction with a mode-selective transmission grating to facilitate wavelength sweeps. Also described is an approach to aligning the selected cavity mode of the tunable laser with the grating filter spectrum of the laser, and minimizing cavity losses in the laser, by indirectly monitoring how well the laser beam inside the resonant cavity is aligned with the laser's gain medium. Movement of the intracavity beam relative to the gain medium can, in principle, provide a good feedback signal for alignment. However, it is often impractical to place detectors around the gain medium and shield them from stray light to directly measure the beam position in the laser. In accordance with various embodiments, this constraint is circumvented by creating an image of the intracavity beam, herein also referred as a "monitoring beam," using a second transmission grating to diffract the zero-order transmission of the mode-selective transmission grating used inside the resonant cavity. The monitoring beam can be focused down to create an image of the beam spot that the intracavity beam creates on the gain medium. The displacement of that monitoring beam spot from a position associated with mode-to-filter alignment can be used as a feedback control signal to adjust the mode-selective grating and/or the controllable mirror.

The foregoing summary will be more readily understood from the following detailed description of the drawings.

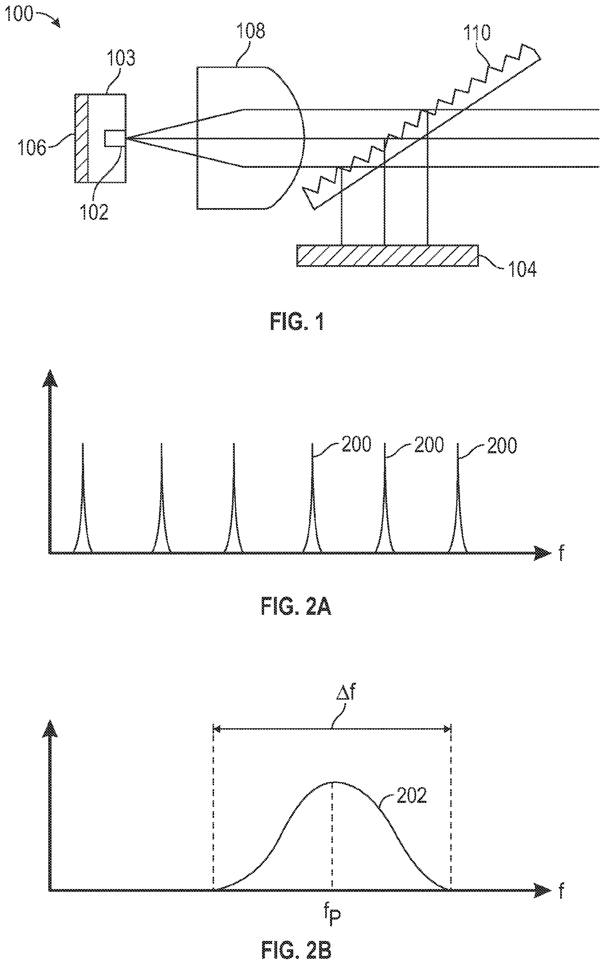

FIG. 1 illustrates a basic configuration of an example tunable laser 100 in accordance with various embodiments. The laser 100 (viewed in top view, that is, in a projection onto the plane in which the beam propagates, herein also the "laser plane") includes a resonant cavity and, inside the resonant cavity, a gain medium 102, where stimulated emission takes place. In the illustrated example, the gain medium 102 is the gain channel of a diode gain block 103. However, other types of gain media, such as doped glass (e.g., fused silica doped with erbium or ytterbium), doped crystals (YAG, titanium sapphire, ruby), gases (argon, neon, helium, fluorine), and dyes in solvents, may alternatively be used. The resonant cavity is formed between two resonator mirrors 104, 106. One of the resonator mirrors (as shown mirror 104) is controllable, and serves as the tuning element for the laser wavelength; this mirror 104 is herein also referred to as the "controllable resonator mirror" or "controllable mirror." The other, fixed mirror 106 may be formed by the back facet of the diode gain block 103, as shown. Alternatively, a separate mirror may be placed on the side of the gain medium 102 opposite to the controllable mirror 104. Regardless of the specific implementation, the fixed mirror 106 is generally configured to couple a portion of the laser light out of the cavity and into optics that use the laser light for some purpose. Inside the cavity, a lens 108 may focus light onto the gain medium 102, and collimate the reflected light coming from the gain medium 102.

The laser 100 further includes an intracavity transmission grating 110 (herein also referred to more simply as "transmission grating 110" or simply "grating 110"), that is, a diffraction grating that transmits, rather than reflects, the diffracted light. The transmission grating 110 is placed between the controllable mirror 104 and the gain medium 102, and acts as a selective loss, or filter, that limits the wavelengths that can be present in the cavity. The controllable mirror 104 is positioned in the path of the first-order (or a higher-order) diffraction of the transmission grating 110, such that light between the grating 110 and the controllable mirror 104 propagates at an angle (e.g., approximately a right angle) with respect to light between the gain medium 102 and the grating 110.

FIG. 2A schematically shows the spectrum of cavity modes 200 of the laser 100, illustrating their even frequency spacing. The frequencies (and, thus, wavelengths) of the cavity modes 200 depend on the cavity length, which can be changed, e.g., by moving the controllable mirror 104 closer to or farther from the grating 110.

FIG. 2B schematically shows the filter spectrum 202 of the laser, which depends on the configuration of the transmission grating 110 and the mirror 104. Only cavity modes 200 with wavelengths within the filter spectrum 202 can exist in the cavity; the transmission grating 110, thus, functions as a mode-selecting element. The spectral width $\Delta f$ of the filter spectrum 202 is a function of the width of the region of the grating 110 that is illuminated by the beam in the cavity. The spectral location of the filter spectrum 202, e.g., as defined in terms of its peak frequency $f_P$ (corresponding to peak wavelength $\lambda_P$), depends on the angles at which the light is incident upon and diffracted from the grating 110 and the angle of the mirror 104. More specifically, the position of the peak of the filter spectrum is determined in accordance with the grating equation:

$$d(\sin\theta_i - \sin\theta_m) = m\lambda,$$

where $d$ is the periodicity of the diffraction grating (e.g., the distance between adjacent grooves in a ruled grating), $\theta_i$ is the angle of incidence of light coming from the gain medium 102 onto the grating, $\theta_m$ is the angle of diffraction of diffraction order m (m being an integer), and $\lambda$ is the wavelength. For a particular angle of incidence ($\theta_i$), the wavelength of the filter peak $\lambda_P$ changes proportionally to the sine of the diffraction angle $\theta_m$ associated with the portion of the light in the cavity that is reflected back into the gain medium, and this angle can be controlled by the mirror 104. That is, among light diffracted at multiple angles, the resonator mirror 104 selects, by virtue of its orientation relative to the grating 110, light at one angle to be reflected back into the gain medium 102. Accordingly, the filter spectrum 202 of the laser 100 can be shifted by rotating the mirror 104 in the laser plane.

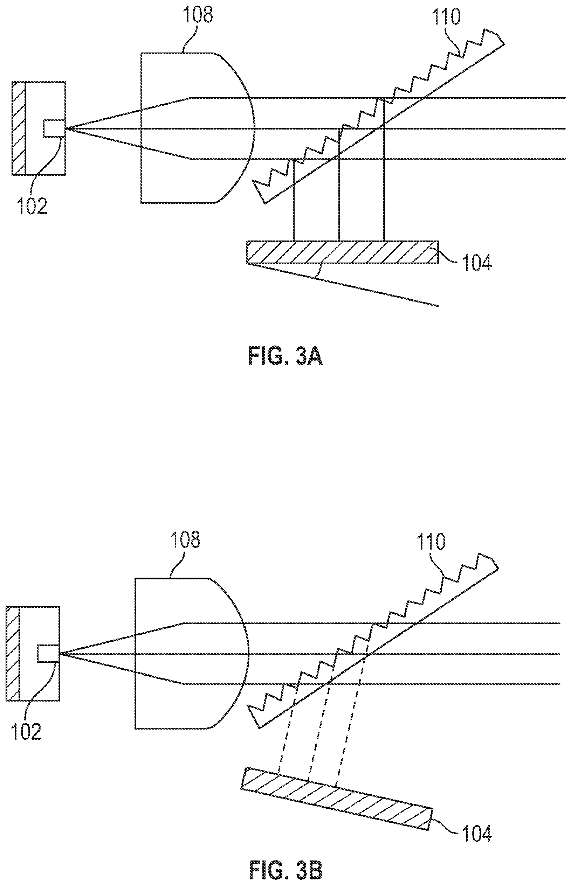

To illustrate this concept, FIGS. 3A and 3B depict, in top views, different relative orientations between the controllable mirror 104 and the transmission grating 110 of the laser 100, illustrating tuning of the filter spectrum 202 in accordance with various embodiments. The grating 110 is at a fixed position and orientation relative to the gain medium 102 (resulting in a fixed angle of incidence, $\theta_i$, onto the grating 110), but the controllable resonator mirror 104 is oriented at two different angles relative to the grating 110 in FIGS. 3A and 3B, respectively. The grating 110 diffracts light of different wavelengths (illustrated by solid and dashed lines, respectively) at different respective angles, and whichever wavelength is incident normally onto the mirror 104 is reflected back into the gain medium 102, and thereby enhanced in the cavity. Tilting the mirror, thus, effectively shifts the filter spectrum 202 so that its peak occurs at a different frequency $f_P$ and wavelength $\lambda_p$.

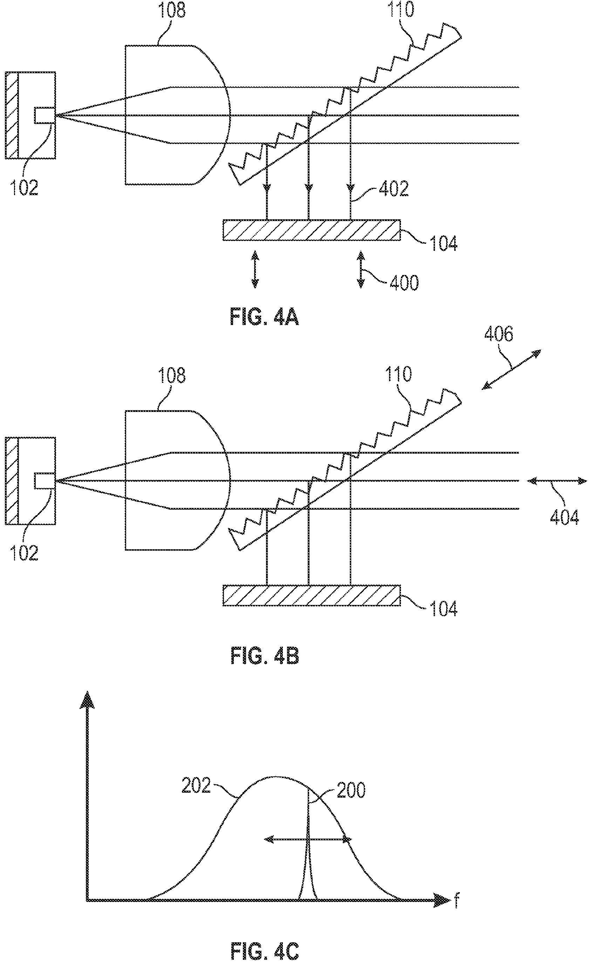

FIGS. 4A and 4B illustrate, in top views of the laser 100, various ways of shifting the cavity modes 200 of the laser without changing the filter spectrum 202. FIG. 4C illustrates the spectral shifting of the cavity modes in a schematic depiction of the spectrum of the cavity modes 200 relative to the filter spectrum 202. The wavelength locations of the modes are determined by the following equation:

$$2\pi N = \frac{2\pi L_{opt}}{\lambda} + \varphi,$$

where $N$ is an integer, $L_{opt}$ is the optical length of the cavity, $\lambda$ is the wavelength, and $\varphi$ is the sum of all of the phase shifts that occur in the cavity (such as at grating diffractions and metal reflections). Moving the mirror 104 in the general direction 400 normal to the mirror surface (which is the direction of the diffracted beam 402 that will be reflected back onto the grating 110), as shown in FIG. 4A, causes a change in the optical length of the cavity, $L_{opt}$, specifically, the portion of the cavity between the grating 110 and the mirror 104. Alternatively, the optical length of the cavity can be changed by translating the grating 110 in a direction 404, parallel to the collimated beam that exits the lens 108, without changing the orientation of the grating, as indicated in FIG. 4B; in this case, the length of the cavity portion between the gain medium 102 and the grating 110 changes. It is also possible to translate the grating 110 in a direction 406, parallel to a plane of the grating 110, again without changing the orientation of the grating. The translating in this direction 406 does not cause a change in the cavity length, but it does cause a change in the phase shift, $\varphi$. As will be appreciated, any translation of the grating 110 in the laser plane can be described as a superposition of translations in directions 404, 406, and causes a shift in the cavity modes 200 due to some combination of a change in the optical length $L_{opt}$ and the phase shift $\varphi$ in the cavity.

Accordingly, changing the angle of the mirror 104 within the laser plane enables tuning the location of the filter spectrum 202, while moving the controllable mirror 104 so as to adjust the distance between the mirror 104 and the grating 110, or shifting the grating 110 to adjust the distance between the gain medium 102 and the grating 110 or the phase shift in the cavity, allows tuning the locations of the cavity modes 200, independently from the filter spectrum 202. Together, mirror angle and mirror distance to grating or grating position can be used to control the locations of the cavity modes 200 relative to the filter spectrum 202, and thereby to select a single mode that is present in the cavity, as a result of being amplified more than any other mode.

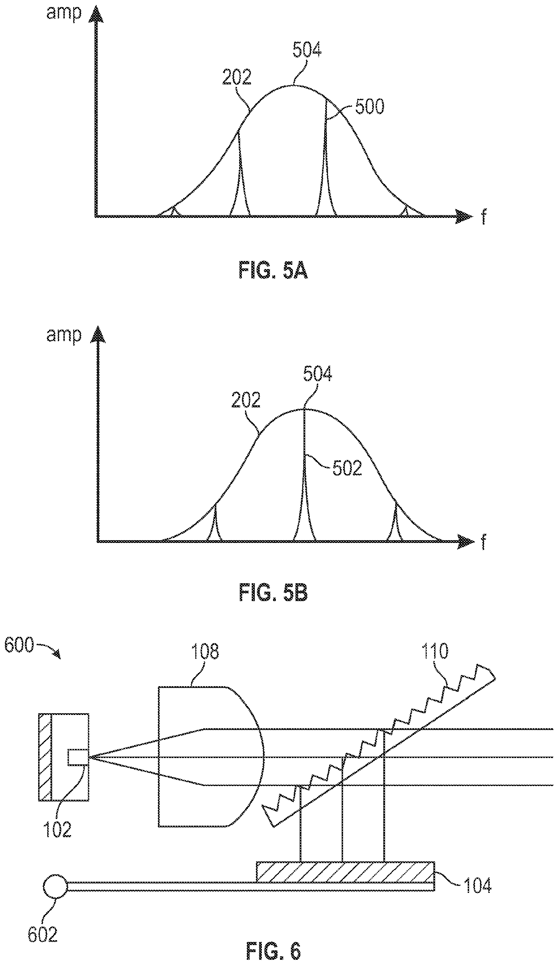

FIGS. 5A and 5B illustrate two relative positions between cavity modes 200 and filter spectrum 202, and indicate the respective selected modes 500, 502, which correspond to the modes with the highest gain. It is often desirable that the selected mode 502 is aligned with the peak 504 of the filter spectrum 202, as shown in FIG. 5B, to maximize the intensity of the laser light, although, in some cases, it may be desirable that the selected modes is aligned with a position off-set from the filter peak 504. Either way, the alignment between the selected cavity mode 502 and the filter spectrum 202 should be maintained during laser tuning. If the selected cavity mode 500 and the filter peak 504 become misaligned, e.g., if a cavity mode initially aligned with the filter peak 504 shifts away from the peak 504, as shown in FIG. 5B, not only does the beam intensity drop, but mode hopping can occur when another mode comes closer to the filter peak 504. In laser wavelength sweeps, such mode hopping is generally undesirable and should be avoided or at least reduced. Mode-hop-free laser tuning is achieved when the tuning of the selected cavity mode and of the filter spectrum are coordinated in a manner that maintains alignment between the two throughout the wavelength sweep.

FIG. 6 is a schematic top view of an example transmission-grating tunable laser 600 with a controllable mirror movable about a remote pivot point 602, illustrating one approach to achieving continuous alignment, in accordance with an embodiment. The remote pivot point 602 ties the position and angle of the mirror 104 together through a trigonometric relationship. In some instances, this may achieve mode-hop-free tuning. In other situations, the coordination between mirror position and mirror angle via the pivot point 602 does not by itself guarantee the elimination of mode hopping, but reduces any misalignment, and thus the amount of correction needed. Unfortunately, the tolerance on this pivot point 602 is often quite tight, and the trigonometric relationship may only work for a limited tuning range.

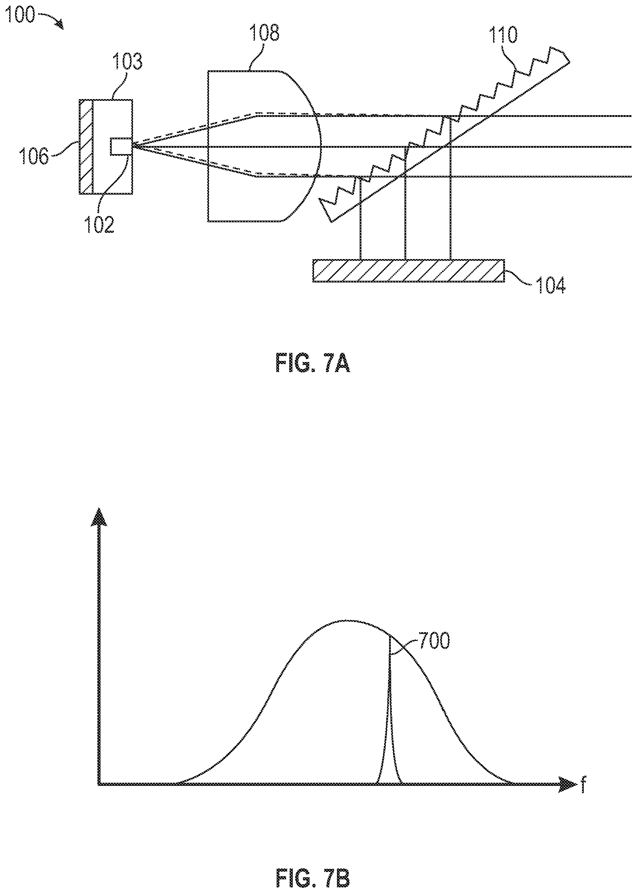

In various embodiments, spectral alignment between the cavity mode and the mode-selective filter is achieved by monitoring the spatial alignment between the intracavity laser beam and the gain medium 102. Considering again the grating equation, $d(\sin\theta_i - \sin\theta_m) = m\lambda$, a laser cavity mode having a wavelength that does not have a diffraction angle $\theta_m$ that produces a beam that is exactly normal to the mirror constitutes an off-center mode. As shown in FIG. 7A, the intracavity beam spot of such an off-center mode 700 is spatially displaced, in the laser plane, from the center of the gain medium 102. Further, the off-center mode 700 is spectrally displaced from the peak of the filter spectrum 202, as illustrated in FIG. 7B, due to diminished coupling into the gain medium 102. Conversely, when the lasing cavity mode is at the low-loss (maximum-diffraction) wavelength of the grating, the diffraction-limited beam spot is well-aligned with the gain medium 102 and couples back into the gain medium 102 with maximum efficiency. Accordingly, the movement of the beam spot relative to the gain medium 102 to satisfy the grating equation is a good indicator of misalignment between the cavity mode and the grating filter.

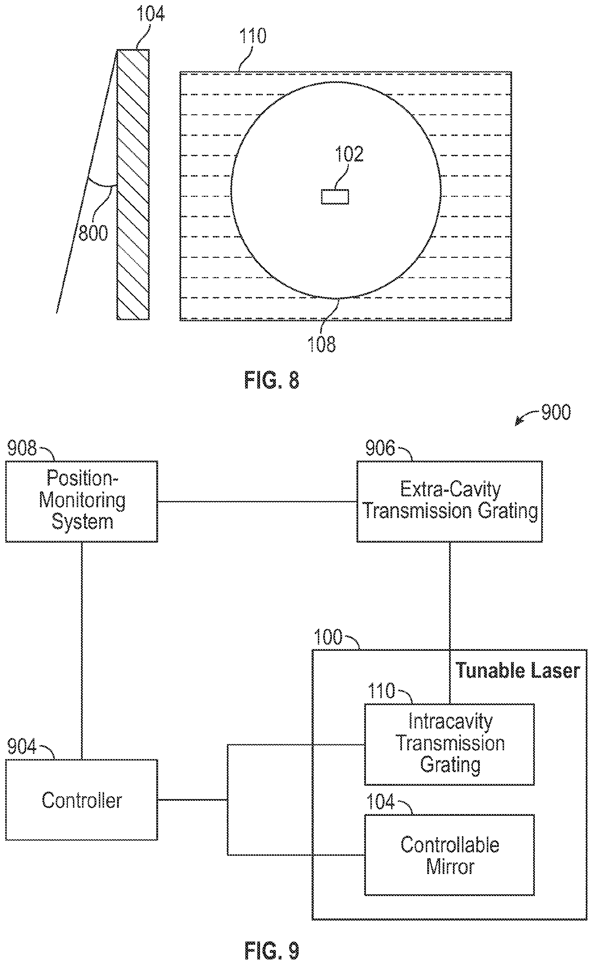

The controllable mirror 104, in addition to being rotatable and translatable in the laser plane, may have one or more additional degrees of freedom. For example, the controllable mirror 104 may have an additional degree of freedom for the tilt angle with respect to the laser plane. FIG. 8 illustrates this tilt angle 800 in a side view of the laser cavity along the collimated diffracted return beam coming from the grating 110 and focused by the lens 108 onto the gain medium 102. The tilt angle 800 is the angle of rotation about an axis defined by the intersection of the mirror plane with the laser plane. It is generally chosen so that the reflected light diffracts off the grating 110 and is focused back onto the gain medium 102. If the tilt angle 800 is off, loss is introduced into the cavity. Accordingly, it is desirable to adjust the tilt angle 800 to achieve alignment of the focused intracavity beam with the gain medium 102 also in the direction normal to the laser plane (e.g., the vertical direction if the laser plane is oriented horizontally). If the laser can be manufactured such that a low-loss angle can be maintained over time and over a range of temperatures, as well as during laser tuning, adjustments to the tilt angle can be eliminated. However, if the tilt angle 800 can be controlled, then the laser can be assembled without tight tolerances, which entails cost benefits. Such control can be achieved using the displacement of the beam spot from the gain medium 102 as a feedback signal.

FIG. 9 is a schematic block diagram of a tunable transmission-grating laser system 900 with feedback control to align the intra-cavity beam in one or two dimension (in the laser plane and/or in direction perpendicular to the laser plane), in accordance with various embodiments. The system 900 includes a tunable laser 100 as described with reference to FIG. 1, with a transmission grating 110 inside the resonant cavity, used for mode selection, and with a controllable resonator mirror 104. The controllable mirror 104 and/or the transmission grating 110 are movable along various degrees of freedom, for instance, by suitable electronically driven actuators, such as translation stages, pistons, electrostatically controlled microelectromechanical systems (MEMS) actuators, voice coil actuators, and/or set screws, as known to those of ordinary skill in the art. In some embodiments, the controllable mirror 104 can be moved linearly in the laser plane generally away from or towards the transmission grating 110, as well as be rotated within the laser plane and tilted relative to the laser plane (as described with reference to 3A-4B). The transmission grating 110 itself may likewise be movable linearly in the laser plane (as illustrated with reference to FIG. 4B).

A controller 904 can control these degrees of freedom for the motion of the mirror 104 and transmission grating 110 to tune the wavelength of the tunable laser 100 while aligning the laser beam with the gain medium. The controller may be implemented by any suitable combination of hardware and/or software. For example, in some embodiments, the controller is implemented by a digital signal processor (DSP), application-specific integrated circuit (ASIC), field-programmable gate array (FPGA), or other electronic circuitry. In other embodiments, the controller is implemented in software running on a general-purpose computer, that is, with processor-executable instructions stored in memory and executed by one or more hardware processors of the computer. The instructions may also be stored separately on any machine-readable medium, that is, any medium that is capable of storing, encoding, or carrying instructions for execution by a computing machine, along with any data structures used by or associated with such instructions. Non-limiting machine-readable medium examples include solid-state memories, and optical and magnetic media. Specific examples of machine-readable media include: non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magneto-optical disks; Random Access Memory (RAM); Solid State Drives (SSD); and CD-ROM and DVD-ROM disks. In some examples, the machine-readable media include non-transitory machine readable media.

The system 900 further includes a second transmission grating 906 outside the resonant cavity (hereinafter also referred to as the "extra-cavity transmission grating" 906) that refracts the zero-order transmission of the intracavity transmission grating 110 to generate a monitoring beam, and a position-monitoring subsystem 908 to measure the movement of a monitoring beam spot and its displacement from a position that corresponds to intracavity-beam alignment with the gain medium. As noted, the creation of such a monitoring beam and beam spot serves to get around spatial constraints inside the cavity that would make detector placement near the gain medium 102 impractical if not impossible. The measured position or displacement of the monitoring beam spot is provided as a feedback signal to the controller 904, which can then adjust resonator mirror 104 and transmission grating 110 accordingly.

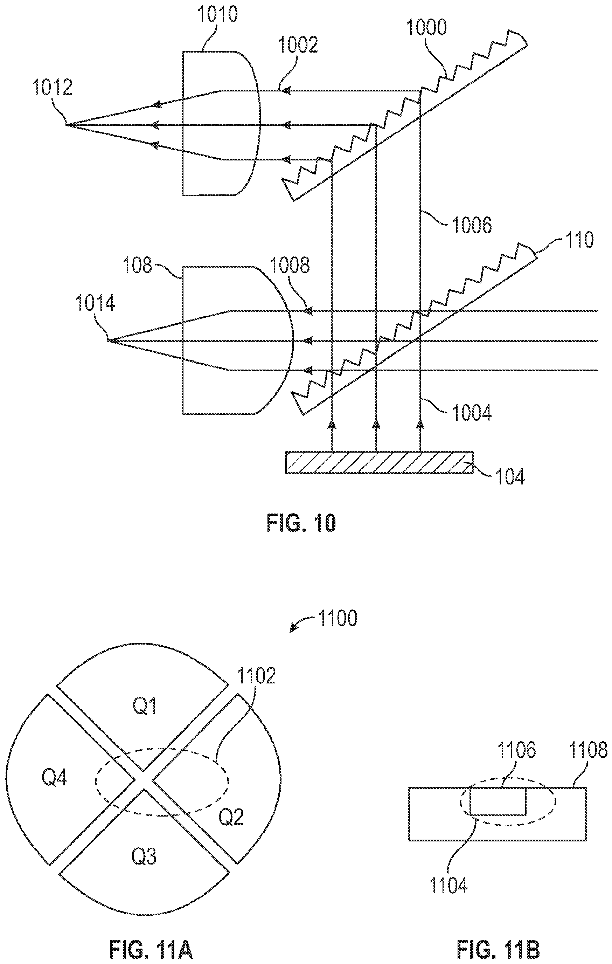

FIG. 10 is a schematic top view of the tunable laser 100 along with a second, extra-cavity transmission grating 1000 (corresponding to grating 906) to create a monitoring beam 1002, in accordance with various embodiments, that allows indirectly measuring the displacement of the intracavity laser beam from the gain medium 102. The second transmission grating 1000 is placed outside the resonant cavity, in the path of the zero-order transmission (through the transmission grating 110, disposed intracavity) of the return beam 1004 coming from the controllable mirror 104; this zero-order transmission is herein also referred to as the "zero-order return beam" 1006, whereas the diffraction of the return beam 1004 back into the gain medium 102 is referred to as the "refracted return beam."

The second transmission grating 1000 is oriented parallel to the transmission grating 110, or more generally, at an angle relative to the path of the zero-order return beam 1006 equal to an angle of the transmission grating 110 relative to the return beam 1004 (to allow for redirection of the zero-order return beam 1006 before it encounters the second transmission grating 1000). With this orientation of the second transmission grating 1000, the produced monitoring beam 1002 will be an image of the diffracted return beam 1008. The monitoring beam 1002 can be focused, e.g., by a lens 1010 or other focusing optic, to a monitoring beam spot 1012 that is an image of the beam spot 1014 on the gain medium 102 inside the resonant cavity. If that lens 1010 has the same focal length as the lens 108, the monitoring spot 1012 will be substantially identical to the beam spot 1014. There are advantages, however, to focusing the monitoring beam 1002 through a lens with longer focal length, as this will make the monitoring beam spot 1012 bigger and the spatial deflection from its alignment position larger. It is also possible to have no lens at all and simply place the position sensor in the for field of the beam, but this is generally impractical because of the large propagation distances needed. The position of the monitoring beam spot 1012 can be measured in various ways, as illustrated below with reference to FIGS. 11A-15B. Detectors and other means for measuring the beam spot, along with the focusing lens 1010, constitute the position-monitoring subsystem 908.

In some embodiments, the monitoring beam spot is measured with a position-sensitive detector placed at the focal plane of the lens 1010. As one example of a position-sensitive detector, FIG. 11A shows, in front view, a quadrant detector 1100, along with the position of the monitoring beam spot 1102 relative to the detector 1100. For comparison, FIG. 11B shows, in side view, the position of the intracavity beam spot 1104 relative to the gain channel 1106 of a diode gain block 1108, which may serve as the gain medium 102 in one embodiment. As can be seen, the intracavity beam spot 1104 is slightly displaced from the center of the gain channel 1106. If the quadrant detector 1100 is positioned, e.g., based on a calibration process preceding a measurement, such that, for an aligned intracavity laser beam, the monitoring beam spot would be centered on the detector 1100, the misalignment shown in FIG. 11B will be reflected by an off-center position of the monitoring beam spot 1102 on the detector, as shown in FIG. 11A.

The amount of misalignment can be quantified by measuring the difference in the amount of detected light (as will translate into a difference in photocurrents) between opposing quadrants of the detector 1100. A misalignment in the laser plane (as shown), corresponding to a cavity mode that does not coincide with the filter spectrum peak, will result in a non-zero photocurrent difference between quadrants Q2 and Q4. A vertical, out-of-plane misalignment, as results when the tilt angle of the controllable mirror 104 relative to the laser plane is off, would result in a non-zero photocurrent difference between quadrants Q1 and Q3. Beneficially, a quadrant detector, e.g., made of indium gallium arsenide (InGaAs) or germanium (Ge), can be used at laser operating wavelengths in the near infrared regime, e.g., at 1550 nm, which is outside the detection band of silicon-based detectors. In addition, the four detectors that make up the quadrant detector 1100 are affordable, and require only a few extra acquisition channels, but have no moving parts.

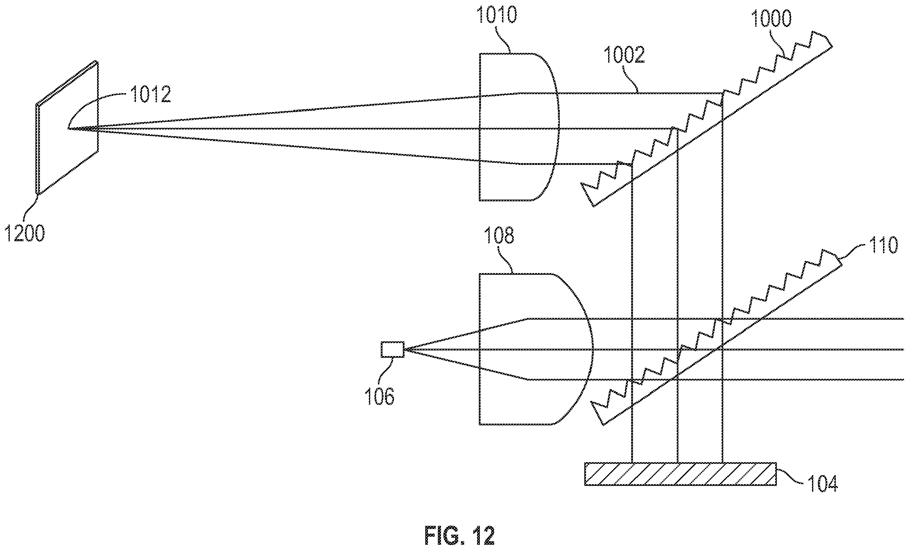

FIG. 12 shows, in a schematic top view, a portion of a tunable laser system that utilizes, as an alternative to a quadrant detector 1100, a position-sensitive diode (PSD) 1200 at the focal plane of the lens 1010 to measure the location of the monitoring beam spot 1012, in accordance with one embodiment. PSDs provide continuous position information based on local resistance changes measured with electrodes connected to the device at various locations.

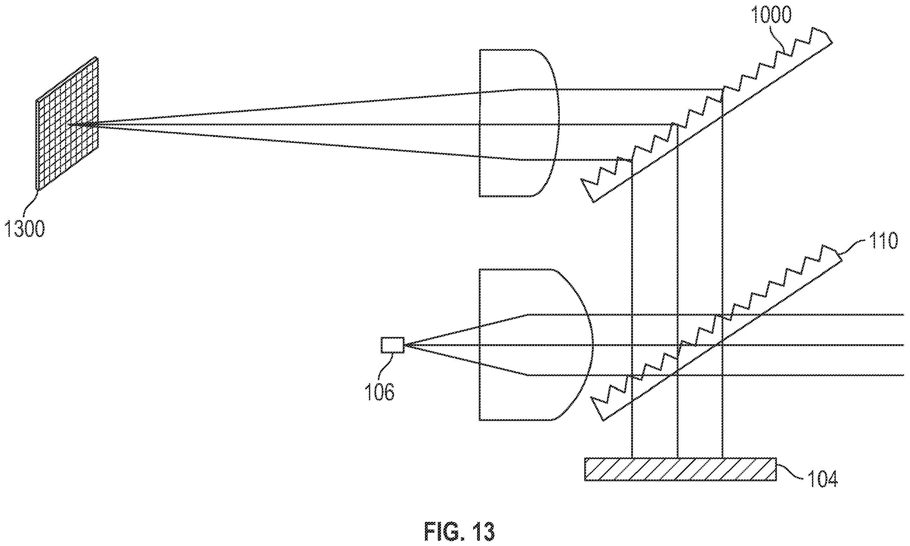

FIG. 13 illustrates, again in schematic top view, yet another embodiment, in which an imaging array 1300 is used to measure the position of the beam spot 1012. Unlike a PSD, the imaging array 1300 provides discrete position information in its pixelated image. The imaging array 1300 may be, for instance, a charge-coupled device whose sensor pixels are implemented by complementary metal oxide semiconductor (CMOS) capacitors. Depending on the operating wavelength range of the tunable laser, a CMOS-based imaging array may or may not be cost-effective. For example, a CMOS-based imaging array that can detect light at wavelengths around 1550 nm, as are often used in OFDR systems, can cost more than $10,000. However, for wavelengths shorter than 1000 nm, silicon-based CMOS imaging arrays, which may be as cheap as about $1, can be used. Accordingly, for short wavelengths, CMOS imaging arrays are a suitable option for a position-sensitive detector to measure the monitoring beam spot.

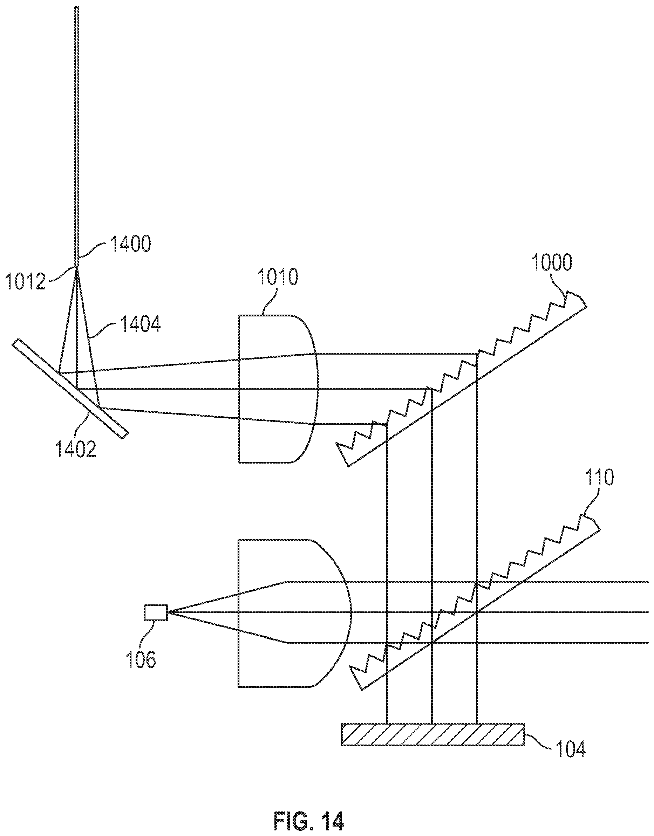

FIG. 14 illustrates, in a schematic top view, a portion of a tunable laser system in which the location of the focused monitoring beam spot 1012 is determined, in accordance with various embodiments, using a single, small area receiver in conjunction with a scanning mirror 1402 (or other beam scanner) in the path between the focusing lens 1010 and the receiver 1400 that scans the focused monitoring beam 1404 across the receiver 1400. In this position-monitoring system, the receiver 1400 is kept at a fixed location, and the scanning mirror 1402 is moved linearly, e.g., towards or away from the focusing lens 1010, or rotated on the laser plane, to move the monitoring beam spot 1012. The receiver 1400 may, for instance, be an individual photodetector, or as shown, the input face of an optical fiber coupled, at the other end, to a photodetector.

The mirror position and/or orientation can be calibrated by aligning the intracavity beam with the gain medium, and then translating or rotating the mirror 1402 to scan the focused monitoring beam 1404 across an area including the receiver 1400, and determining the position and/or orientation of the mirror 1402 in the laser plane at which the focused monitoring beam 1404 is detected at the receiver 1400 and the measured intensity is maximized. When the laser is subsequently misaligned, the monitoring beam spot 1012 will generally no longer coincide with the receiver 1400. The misalignment of the laser can then be quantified by determining the distance by which the mirror 1042 needs to be moved, or the angle by which it needs to be rotated, relative to the calibrated position or orientation, to redirect the focused monitoring beam 1404 onto the receiver 1400. It is also possible, alternatively, to use the position-monitoring system of FIG. 12 in a manner similar to the quadrant detector of FIG. 11A, by moving the mirror 1402 to four (or more) different predetermined linear positions or orientations, and measuring the detected intensity at the receiver 1400. The mirror motions are, in this case, chosen sufficiently small to keep the monitoring beam spot 1012 overlapping with the receiver 1400, allowing the receiver 1400 to measure the intensity at different locations within the monitoring beam spot 1012. Using a scanning mirror 1402 to measure the monitoring beam has the benefit that only a single detection channel is needed, which, however, comes at the cost of moving parts and usually multiple sweeps.

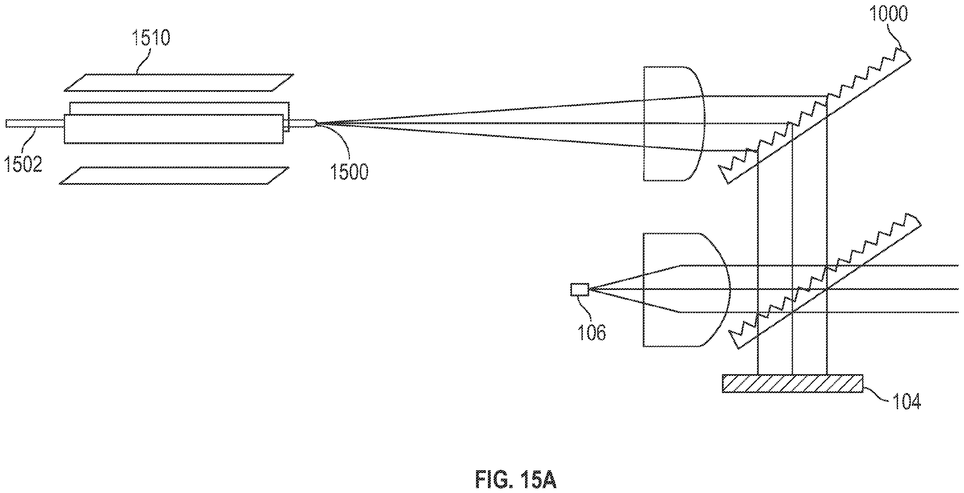

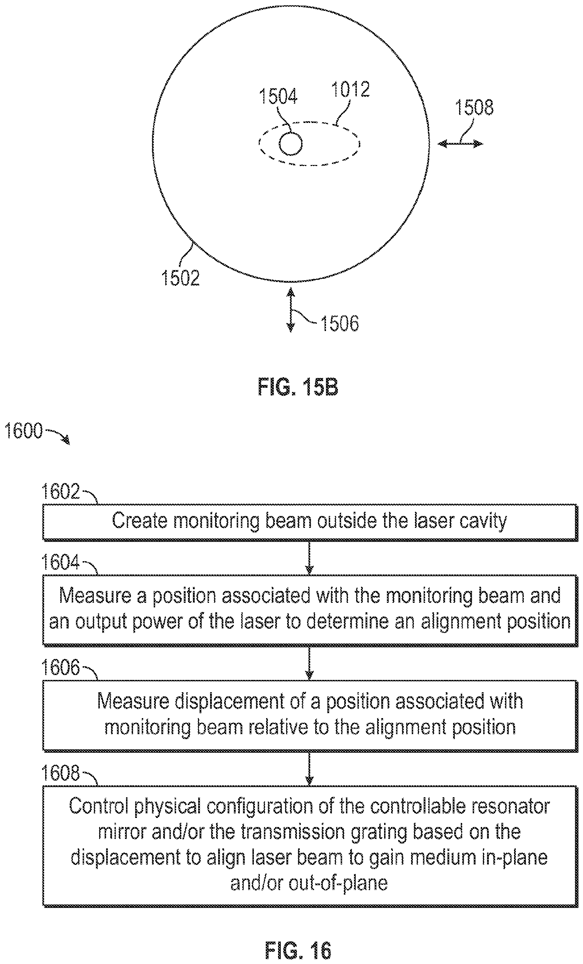

FIG. 15A illustrates, in a schematic top view, of a portion of a tunable laser system that likewise uses a small-area receiver 1500, but moves the receiver itself, rather than the monitoring beam as in FIG. 14. Here, too, the receiver 1500 may be, for example, an individual photodetector, or the input face of an optical fiber 1502 (as shown) coupled, at the other end, to a photodetector. FIG. 15B is a front view of an example fiber-based receiver as may be used in this embodiment, illustrating the relative sizes of the monitoring beam spot 1012, the fiber 1502, and the fiber core 1504. In one example, the fiber is a 125 $\mu$m standard optical fiber with a 9 $\mu$m fiber core. The input face of the fiber 1502 may be moved, e.g., by up to 100 $\mu$m in both directions, both vertically (1506) and horizontally (1508). Fiber movement may be accomplished, for instance, using electrostatic fields generated between pairs of capacitor plates 1510, or by magnetic or piezoelectric means.

FIG. 16 is a flowchart of a method 1600 of aligning, in a tunable laser 100, the intracavity beam with the gain medium, in accordance with various embodiments. The method 1600 involves creating a monitoring beam outside the laser cavity by diffracting a zero-order return beam transmitted through the intracavity grating off a second, extra-cavity transmission grating (1602). The monitoring beam serves as an image of the intracavity beam, and its focused beam spot, or some other position associated with the monitoring beam, can be used to determine whether the intracavity beam is aligned. For this purpose, the alignment position of the monitoring beam spot, that is, the position of the beam spot when the intracavity beam is aligned with the gain medium (in the laser plane by virtue of the alignment of the lasing cavity mode with the laser's filter peak, or in a direction perpendicular to the laser plane) is determined, e.g., in a calibration step (1604).

Calibration (at 1604) may be performed by scanning the controllable resonator mirror 104 of the tunable laser over a range of angles and linear positions while the output power of the laser and the monitoring spot position are monitored. From this data, a map of the spot position versus laser output power can be generated. The alignment position of the monitoring spot is generally the position at which the laser output power is maximized. Instead of measuring and recording the position of the monitoring beam spot itself, it is also possible to monitor a position otherwise associated with the monitoring beam spot, such as the angular position (in other words, orientation) of a scanning mirror when the mirror redirects the monitoring beam onto a fixed receiver, as illustrated in FIG. 14. The alignment position of the scanning mirror is the angular position at which the mirror directs the monitoring beam onto the receiver when the intracavity beam is aligned with the gain medium. The calibration may be performed, e.g., upon start-up of the laser, and thereafter as needed, e.g., to compensate for laser drift over time and/or temperature.

Following calibration, the displacement of the beam spot, or other position associated with the monitoring beam, from the alignment position can be measured (1606) and used as feedback to control the physical configuration of the controllable resonator mirror 104, the transmission grating 110, or both (1608). Control parameters of the configuration include, for example, the position of the controllable mirror along the direction of the return beam and the position of the transmission grating 110 in the laser plane, both of which affect the cavity modes, as well as the tilt angle of the controllable mirror 104, which determines the out-of-plane alignment of the focused intracavity beam with the gain medium 102.

Adjustments to the control parameters may in principle be made in real-time as the laser is being tuned, e.g., using a control signal output by a proportional-integral-derivative (PID) controller. In many systems and applications, however, the laser sweep rate is too high for real-time adjustments to be feasible. For example, if a CMOS or similar imaging array is used in the position-monitoring subsystem, the read-out rate from the array may be significantly lower than the sweep rate. However, swept lasers often operate in a quasi-steady state, where the drive signals to the controllable mirror 104 and/or a gain diode providing the gain medium are repetitive and generally occur at above 100 Hz. In such systems, it is possible to characterize the sweep, in terms of the monitoring beam position as a function of drive signal or wavelength, over the course of multiple sweeps, and then make adjustments at a rate lower than sweep rate. With an imaging array determining the position of the beam monitoring spot, for example, a fast global shutter may be used to expose the array during each sweep for only a brief slice of the total sweep, and this slice is then advanced relatively slowly through the sweep. If a sweep takes, for instance, 3 ms, and the exposed slice covers 5 $\mu$s, then after six hundred samples, the full sweep is characterized. If, further, the imaging array can be read at thirty frames per second, it will take twenty seconds to fully characterize the sweep. In practice, the spot may be very localized, such that it suffices to read out a much smaller set of pixels. This region-of-interest (ROI) read-out of an imaging array is very common for CMOS devices, and may allow effective frame rates above, e.g., 600 Hz, corresponding to an update rate of about 1 Hz.

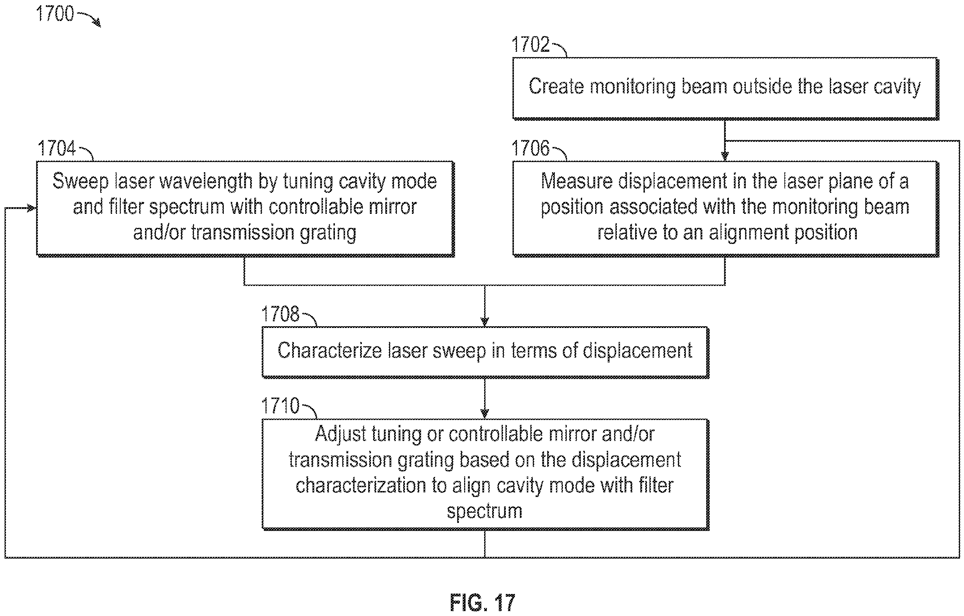

FIG. 17 is a flowchart of a method 1700 of mode-hop-free laser tuning, in accordance with various embodiments, as an example application of the general alignment method of FIG. 16. The mode-hop-free tuning method 1700 includes creating a monitoring beam outside the laser cavity (1702) and, as the laser wavelength is swept (1704), measuring the displacement, in the laser plane, of a position associated with the monitoring beam relative to its alignment position (1706). Performing the laser sweep (1704) involves simultaneously tuning the cavity mode and the filter spectrum of the laser, using the linear position of the controllable mirror 104 or the grating 110 to tune the mode and the rotational angle of the controllable mirror 104 to tune the filter. If the mode and filter spectrum do not remain aligned throughout the sweep, a non-zero displacement will be measured (in 1706). The displacement measurements across the wavelength tuning range may be measured over multiple sweeps, and are then assembled into a curve characterizing the laser sweep in its entirety (1708). This characterization is used, by controller 904, to adjust the drive forms for tuning the controllable mirror 104 and/or the transmission grating 110, to better align the cavity mode with the filter spectrum (1710). The characterization and adjustment process can be repeated throughout subsequent sweeps.

Although the various aspects of the present invention have been described with respect to a preferred embodiment, it will be understood that the invention is entitled to full protection within the full scope of the appended claims.

## Claims

1. A method for aligning a diffracted return beam with a gain medium comprised by a tunable laser system further comprising a mode-selective first transmission grating disposed in a resonant cavity between a gain medium and a controllable resonator mirror, the diffracted return beam resulting from diffraction of a return beam from the controllable resonator mirror off the first transmission grating, the method comprising:

   creating a monitoring beam outside the resonant cavity by diffracting, off a second transmission grating disposed outside the resonant cavity, a zero-order return beam transmitted through the first transmission grating;
   measuring a displacement of a position associated with the monitoring beam relative to an alignment position; and
   controlling a physical configuration based on the measured displacement, the physical configuration being of the controllable resonator mirror, or of the first transmission grating, or of both the controllable resonator mirror and the first transmission grating.

2. The method of claim 1, wherein:

   the controllable resonator mirror has a position along a direction of the return beam;
   a laser plane is defined by the return beam and the diffracted return beam;

measuring the displacement comprises: measuring a displacement in the laser plane of the position associated with the monitoring beam relative to the alignment position; and controlling the physical configuration comprises: controlling the position of the controllable mirror along the direction of the return beam or the position of the first transmission grating in the laser plane to align a cavity mode of a laser of the tunable laser system with a filter spectrum associated with the first transmission grating and the controllable resonator mirror.

3. The method of claim 1, wherein:

a laser plane is defined by the return beam and the diffracted return beam; the controllable resonator mirror has a tilt angle with respect to the laser plane; measuring the displacement comprises: measuring a displacement out of the laser plane of the position associated with the monitoring beam from the alignment position; and controlling the physical configuration comprises: controlling the tilt angle of the resonator mirror based on the measured displacement out of the laser plane to align the diffracted return beam with the gain medium in a direction normal to the laser plane.

4. The method of any of claims 1 to 3, further comprising:

focusing the monitoring beam onto a position-sensitive detector, wherein the position associated with the monitoring beam is a position of the focused monitoring beam on the position-sensitive detector; or focusing the monitoring beam and using a scanning mirror to scan the focused monitoring beam across an area containing a small-area receiver, wherein the position associated with the monitoring beam corresponds to an orientation of the scanning mirror when the focused monitoring beam is incident on the small-area receiver; or focusing the monitoring beam and scanning the small-area receiver across an area intersected by the focused monitoring beam, wherein the position associated with the monitoring beam corresponds to a position of the small-area receiver within the scanned area when the focused monitoring beam is incident on the small-area receiver.

5. A tunable laser system comprising:

a first resonator mirror and a second resonator mirror, the first and second resonator mirrors forming a resonant cavity, the first resonator mirror being controllable; a gain medium disposed inside the resonant cavity; a mode-selecting first transmission grating disposed inside the resonant cavity between the gain medium and the controllable resonator mirror, the first transmission grating configured to generate, from a return beam received from the controllable resonator mirror, a diffracted return beam and a zero-order return beam; a second transmission grating disposed outside the resonant cavity in a path of the zero-order return beam, the second transmission grating configured to diffract the zero-order return beam to generate a monitoring beam; a position monitoring subsystem configured to measure a displacement of a position associated with the monitoring beam relative to an alignment position; and a controller configured to control a physical configuration based on the measured displacement, the physical configuration being of the controllable resonator mirror, or of the first transmission grating, or of both the controllable resonator mirror and the first transmission grating.

6. The tunable laser system of claim 5, wherein the physical configuration comprises at least one parameter selected from the group consisting of a position of the controllable resonator mirror along a direction of the return beam, a position of the first transmission grating in a laser plane defined by the return beam and the diffracted return beam, and a tilt angle of the controllable resonator mirror with respect to the laser plane.

7. The tunable laser system of claim 6, wherein

the position monitoring subsystem is configured to measure the displacement by: measuring a displacement in the laser plane of the position associated with the monitoring beam relative to the alignment position; and the controller is configured to control the physical configuration by: controlling the position of the controllable mirror along the direction of the return beam or the position of the first transmission grating in the laser plane to align a cavity mode of a laser of the tunable laser system with a filter spectrum associated with the first transmission grating and the controllable resonator mirror.

8. The tunable laser system of claim 6, wherein:

the controller is further configured to: tune a wavelength position of a filter spectrum associated with the first transmission grating and the controllable resonator mirror by adjusting an orientation of the controllable resonator mirror in the laser plane;

the position monitoring subsystem is configured to measure the displacement in the laser plane by: measuring the displacement in the laser plane across a tuning range of the wavelength position of the filter spectrum; and

the controller is further configured to control, while the filter spectrum is being tuned, the position of the controllable resonator mirror along the direction of the return beam or the position of the first transmission grating in the laser plane based on the displacement in the laser plane measured, for an instantaneous wavelength position of the filter spectrum, to achieve mode-hop-free wavelength tuning.

9. The tunable laser system of claim 8, wherein:

the position monitoring subsystem is configured to measure the displacement in the laser plane while the filter spectrum is being tuned; and

the controller is configured to control the position of the controllable resonator mirror by: controlling in a feedback control loop.

10. The tunable laser system of claim 6, wherein:

the position monitoring subsystem is configured to measure the displacement by: measuring a displacement out of the laser plane of the position associated with the monitoring beam from the alignment position; and

the controller is configured to control the physical configuration by: controlling the tilt angle of the resonator mirror based on the measured displacement out of the laser plane to align the diffracted return beam with the gain medium in a direction normal to the laser plane.

11. The tunable laser system of claim 6, wherein:

the position monitoring subsystem is configured to measure the displacement by: measuring the displacement both in the laser plane and out of the laser plane; and

the controller is configured to control the physical configuration by: controlling the position of the controllable resonator mirror along the direction of the return beam or the position of the first transmission grating in the laser plane, and controlling the tilt angle of the controllable mirror.

12. The tunable laser system of claim 6, wherein the controller is further configured to:

create, based on the position associated with the monitoring beam and an output power of a laser of the laser system over a range of positions and over a range of tilt angles of the resonator mirror, a mapping between the position associated with the monitoring beam and the output power, the range of positions being of the controllable resonator mirror along the direction of the return beam or of the first transmission grating in the laser plane; and

determine the alignment position based on the mapping.

13. The tunable laser system of any of claims 5 to 12, further comprising:

a first focusing optic, disposed inside the resonant cavity, to focus the diffracted return beam onto the gain medium; and

a second focusing optic, disposed outside the resonant cavity, to focus the monitoring beam, wherein a focal length of the second focusing optic is greater than a focal length of the first focusing optic.

14. The tunable laser system of claim 5, wherein the position monitoring subsystem comprises:

a position-sensitive detector disposed in a path of the monitoring beam, and wherein the position associated with the monitoring beam corresponds to a position of the monitoring beam on the position-sensitive detector;

a small-area receiver and a beam scanner, the beam scanner configured to scan the monitoring beam across an area containing the small-area receiver, wherein the position associated with the monitoring beam corresponds to an orientation of the beam scanner when the monitoring beam is incident on the small-area receiver; or a movable small-area receiver and an actuation mechanism configured to move the small-area receiver across an area intersected by the monitoring beam, wherein the position associated with the monitoring beam corresponds to a position of the movable small-area receiver when the monitoring beam is incident on the movable small-area receiver;

a small-area receiver configured to receive incident light from the monitoring beam, the small-area receiver comprising a photodetector, or an input face of an optical fiber coupled to a photodetector at an output end of the optical fiber.

15. A machine-readable medium comprising a plurality of machine-readable instructions which when executed by one or more processors associated with a tunable laser system comprising a mode-selective first transmission grating disposed in a resonant cavity between a gain medium and a controllable resonator mirror, cause the one or more processors to perform the method of any of claims 1 to 4.

**Patentansprüche**

1. Ein Verfahren zum Ausrichten eines diffraktierten Rückstrahls mit einem Verstärkungsmedium bestehend aus einem abstimmbaren Lasersystem, ferner umfassend ein modusselektives erstes Übertragungsgitter, das in einem resonanten Hohlraum zwischen dem Verstärkungsmedium und einem steuerbaren Resonatorspiegel angeordnet ist, wobei der diffraktierte Rückstrahl aus einer Diffraktion eines Rückstrahls aus dem steuerbaren Resonatorspiegel von dem ersten Übertragungsgitter resultiert, wobei das Verfahren Folgendes umfasst:

   Erzeugen eines Überwachungsstrahls außerhalb des resonanten Hohlraums durch Diffraktieren, von einem zweiten Übertragungsgitter, das außerhalb des resonanten Hohlraums angeordnet ist, eines Rückstrahls nullter Ordnung, der durch das erste Übertragungsgitter übertragen wird;
   Messen einer Verlagerung einer mit dem Überwachungsstrahl assoziierten Position relativ zu einer Ausrichtungsposition; und
   Steuern einer physischen Konfiguration basierend auf der gemessenen Verlagerung, wobei die physische Konfiguration eine des steuerbaren Resonatorspiegels oder des ersten Übertragungsgitters oder sowohl des steuerbaren Resonatorspiegels als auch des ersten Übertragungsgitters ist.

2. Das Verfahren nach Anspruch 1, wobei:

   der steuerbare Resonatorspiegel eine Position entlang einer Richtung des Rückstrahls aufweist;
   eine Laserebene durch den Rückstrahl und den diffraktierten Rückstrahl definiert wird;
   das Messen einer Verlagerung Folgendes umfasst: Messen einer Verlagerung in der Laserebene der mit dem Überwachungsstrahl assoziierten Position relativ zu der Ausrichtungsposition; und
   das Steuern der physischen Konfiguration Folgendes umfasst: Steuern der Position des steuerbaren Spiegels entlang der Richtung des Rückstrahls oder der Position des ersten Übertragungsgitters in der Laserebene, um einen Hohlraummodus eines Lasers des abstimmbaren Lasersystems mit einem mit dem ersten Übertragungsgitter und dem steuerbaren Resonatorspiegel assoziierten Filterspektrum auszurichten.

3. Das Verfahren nach Anspruch 1, wobei:

   eine Laserebene durch den Rückstrahl und den diffraktierten Rückstrahl definiert wird;
   der steuerbare Resonatorspiegel einen Neigungswinkel in Bezug auf die Laserebene aufweist;
   das Messen einer Verlagerung Folgendes umfasst: Messen einer Verlagerung von der Laserebene heraus der mit dem Überwachungsstrahl assoziierten Position aus der Ausrichtungsposition; und
   das Steuern der physischen Konfiguration Folgendes umfasst: Steuern des Neigungswinkels des Resonatorspiegels basierend auf der gemessenen Verlagerung von der Laserebene heraus, um den diffraktierten Rückstrahl mit dem Verstärkungsmedium in einer zu der Laserebene senkrechten Richtung auszurichten.

4. Das Verfahren nach einem der Ansprüche 1 bis 3, das ferner Folgendes umfasst:

   Fokussieren des Überwachungsstrahls auf einen positionsempfindlichen Detektor, wobei die mit dem Überwachungsstrahl assoziierte Position eine Position des fokussierten Überwachungsstrahls auf den positionsempfindlichen Detektor ist; oder
   Fokussieren des Überwachungsstrahls und Verwenden eines Scannerspiegels, um den fokussierten Überwachungsstrahl über eine Fläche zu scannen, die einen kleinflächigen Empfänger enthält, wobei die mit dem Überwachungsstrahl assoziierte Position einer Orientierung des Scannerspiegels entspricht, wenn der fokussierte Überwachungsstrahl auf den kleinflächigen Empfänger einfällt; oder
   Fokussieren des Überwachungsstrahls und Scannen des kleinflächigen Empfängers über eine von dem fokussierten Überwachungsstrahl geschnittene Fläche, wobei die mit dem Überwachungsstrahl assoziierte Position einer Position des kleinflächigen Empfängers innerhalb der gescannten Fläche entspricht, wenn der fokussierte Überwachungsstrahl auf den kleinflächigen Empfänger einfällt.

5. Ein abstimmbares Lasersystem, das Folgendes umfasst:

   einen ersten Resonatorspiegel und einen zweiten Resonatorspiegel, wobei der erste und zweite Resonatorspiegel einen resonanten Hohlraum bilden, wobei der erste Resonatorspiegel steuerbar ist;

ein Verstärkungsmedium, das innerhalb des resonanten Hohlraums angeordnet ist;

ein modusselektierendes erstes Übertragungsgitter, das innerhalb des resonanten Hohlraums zwischen dem Verstärkungsmedium und dem steuerbaren Resonatorspiegel angeordnet ist, wobei das erste Übertragungsgitter dazu konfiguriert ist, aus einem aus dem steuerbaren Resonatorspiegel empfangenen Rückstrahl, einen diffraktierten Rückstrahl und einen Rückstrahl nullter Ordnung zu generieren;

ein zweites Übertragungsgitter, das außerhalb des resonanten Hohlraums in einem Pfad des Rückstrahls nullter Ordnung angeordnet ist, wobei das zweite Übertragungsgitter dazu konfiguriert ist, den Rückstrahl nullter Ordnung zu diffraktieren, um einen Überwachungsstrahl zu generieren;

ein Positionsüberwachungssubsystem, das dazu konfiguriert ist, eine Verlagerung einer mit dem Überwachungsstrahl assoziierten Position relativ zu einer Ausrichtungsposition zu messen; und

eine Steuereinheit, die dazu konfiguriert ist, eine physische Konfiguration basierend auf der gemessenen Verlagerung zu steuern, wobei die physische Konfiguration eine des steuerbaren Resonatorspiegels oder des ersten Übertragungsgitters oder sowohl des steuerbaren Resonatorspiegels als auch des ersten Übertragungsgitters ist.

6. Das abstimmbare Lasersystem nach Anspruch 5, wobei die physische Konfiguration mindestens einen Parameter umfasst, der aus der Gruppe ausgewählt ist, die aus Folgendem besteht: einer Position des steuerbaren Resonatorspiegels entlang einer Richtung des Rückstrahls, einer Position des ersten Übertragungsgitters in einer Laserebene, definiert durch den Rückstrahl und den diffraktierten Rückstrahl, und einem Neigungswinkel des steuerbaren Resonatorspiegels in Bezug auf die Laserebene.

7. Das abstimmbare Lasersystem nach Anspruch 6, wobei

das Positionsüberwachungssubsystem dazu konfiguriert ist, die Verlagerung durch Folgendes zu messen: Messen einer Verlagerung in der Laserebene der mit dem Überwachungsstrahl assoziierten Position relativ zu der Ausrichtungsposition; und

die Steuereinheit dazu konfiguriert ist, die physische Konfiguration durch Folgendes zu steuern:

Steuern der Position des steuerbaren Spiegels entlang der Richtung des Rückstrahls oder der Position des ersten Übertragungsgitters in der Laserebene, um einen Hohlraummodus eines Lasers des abstimmbaren Lasersystems mit einem mit dem ersten Übertragungsgitter und dem steuerbaren Resonatorspiegel assoziierten Filterspektrum auszurichten.

8. Das abstimmbare Lasersystem nach Anspruch 6, wobei:

die Steuereinheit ferner zu Folgendem konfiguriert ist: Abstimmen einer Wellenlängenposition eines mit dem ersten Übertragungsgitter und dem steuerbaren Resonatorspiegel assoziierten Filterspektrums durch Justieren einer Orientierung des steuerbaren Resonatorspiegels in der Laserebene;

das Positionsüberwachungssubsystem dazu konfiguriert ist, die Verlagerung in der Laserebene durch Folgendes zu messen: Messen der Verlagerung in der Laserebene über einen Abstimmungsbereich der Wellenlängenposition des Filterspektrums; und

die Steuereinheit ferner dazu konfiguriert ist, während das Filterspektrum abgestimmt wird, die Position des steuerbaren Resonatorspiegels entlang der Richtung des Rückstrahls oder der Position des ersten Übertragungsgitters in der Laserebene basierend auf der gemessenen Verlagerung in der Laserebene zu steuern, für eine momentane Wellenlängenposition des Filterspektrums, um eine modussprungfreie Wellenlängenabstimmung zu erzielen.

9. Das abstimmbare Lasersystem nach Anspruch 8, wobei:

das Positionsüberwachungssubsystem dazu konfiguriert ist, die Verlagerung in der Laserebene zu messen, während das Filterspektrum abgestimmt wird; und

die Steuereinheit dazu konfiguriert ist, die Position des steuerbaren Resonatorspiegels durch Folgendes zu steuern: Steuern eines Rückkopplungsregelkreises.

10. Das abstimmbare Lasersystem nach Anspruch 6, wobei:

das Positionsüberwachungssubsystem dazu konfiguriert ist, die Verlagerung durch Folgendes zu messen: Messen einer Verlagerung von der Laserebene heraus der mit dem Überwachungsstrahl assoziierten Position aus der Ausrichtungsposition.

die Steuereinheit dazu konfiguriert ist, die physische Konfiguration durch Folgendes zu steuern:

Steuern des Neigungswinkels des Resonatorspiegels basierend auf der gemessenen Verlagerung von der Laserebene heraus, um den diffraktierten Rückstrahl mit dem Verstärkungsmedium in einer zu der Laserebene senkrechten Richtung auszurichten.

11. Das abstimmbare Lasersystem nach Anspruch 6, wobei:

das Positionsüberwachungssubsystem dazu konfiguriert ist, die Verlagerung durch Folgendes zu messen: Messen der Verlagerung sowohl in der Laserebene als auch von der Laserebene heraus; und
die Steuereinheit dazu konfiguriert ist, die physische Konfiguration durch Folgendes zu steuern:
Steuern der Position des steuerbaren Resonatorspiegels entlang der Richtung des Rückstrahls oder der Position des ersten Übertragungsgitters in der Laserebene und Steuern des Neigungswinkel des steuerbaren Spiegels.

12. Das abstimmbare Lasersystem nach Anspruch 6, wobei die Steuereinheit ferner zu Folgendem konfiguriert ist:

Erzeugen, basierend auf der mit dem Überwachungsstrahl assoziierten Position und einer Ausgangsleistung eines Lasers des Lasersystems über einen Bereich von Positionen und über einen Bereich von Neigungswinkeln des Resonatorspiegels, einer Zuordnung zwischen der mit dem Überwachungsstrahl assoziierten Position und der Ausgangsleistung, wobei der Bereich von Positionen einer des steuerbaren Resonatorspiegels entlang der Richtung des Rückstrahls oder des ersten Übertragungsgitters in der Laserebene ist; und
Bestimmen der Ausrichtungsposition basierend auf der Zuordnung.

13. Das abstimmbare Lasersystem nach einem der Ansprüche 5 bis 12, das ferner Folgendes umfasst:

eine erste Fokussierungsoptik, die innerhalb des resonanten Hohlraums angeordnet ist, um den diffraktierten Rückstrahl auf das Verstärkungsmedium zu fokussieren; und
eine zweite Fokussierungsoptik, die außerhalb des resonanten Hohlraums angeordnet ist, um den Überwachungsstrahl zu fokussieren, wobei eine Fokallänge der zweiten Fokussierungsoptik größer als eine Fokallänge der ersten Fokussierungsoptik ist.

14. Das abstimmbare Lasersystem nach Anspruch 5, wobei das Positionsüberwachungssubsystem Folgendes umfasst:

einen positionsempfindlichen Detektor, der in einem Pfad des Überwachungsstrahls angeordnet ist und wobei die mit dem Überwachungsstrahl assoziierte Position einer Position des Überwachungsstrahls auf dem positionsempfindlichen Detektor entspricht;
einen kleinflächigen Empfänger und einen Strahlenscanner, wobei der Strahlenscanner dazu konfiguriert ist, den Überwachungsstrahl über eine Fläche zu scannen, die den kleinflächigen Empfänger enthält, wobei die mit dem Überwachungsstrahl assoziierte Position einer Orientierung des Strahlenscanners entspricht, wenn der Überwachungsstrahl auf den kleinflächigen Empfänger einfällt; oder
einen bewegbaren kleinflächigen Empfänger und einen Betätigungsmechanismus, der dazu konfiguriert ist, den kleinflächigen Empfänger über eine von dem Überwachungsstrahl geschnittene Fläche zu bewegen, wobei die mit dem Überwachungsstrahl assoziierte Position einer Position des bewegbaren kleinflächigen Empfängers entspricht, wenn der Überwachungsstrahl auf den bewegbaren kleinflächigen Empfänger einfällt;
einen kleinflächigen Empfänger, der dazu konfiguriert ist, einfallendes Licht von dem Überwachungsstrahl zu empfangen, wobei der kleinflächige Empfänger einen Fotodetektor umfasst, oder von einer Eingangsseite einer optischen Faser, die mit einem Fotodetektor an einem Ausgangsende der optischen Faser gekoppelt ist.

15. Ein maschinenlesbares Medium, das eine Vielzahl von maschinenlesbaren Anweisungen umfasst, die, wenn sie von einem oder mehreren Prozessoren ausgeführt werden, die mit einem abstimmbaren Lasersystem assoziiert sind, das ein modusselektives erstes Übertragungsgitter umfasst, das in einem resonanten Hohlraum zwischen einem Verstärkungsmedium und einem Resonatorspiegel angeordnet ist, den einen oder die mehreren zu Prozessoren veranlassen, das Verfahren nach einem der Ansprüche 1 bis 4 durchzuführen.

**Revendications**

1. Procédé d'alignement d'un faisceau de retour diffracté avec un milieu à gain constitué par un système laser accordable comprenant en outre un premier réseau de transmission à mode sélectif disposé dans une cavité résonnante entre le milieu à gain et un miroir résonateur commandable, le faisceau de retour diffracté résultant de la diffraction d'un faisceau de retour en provenance du miroir résonateur commandable sur le premier réseau de transmission, le procédé consistant à :

  créer un faisceau de surveillance à l'extérieur de la cavité résonante en diffractant, sur un second réseau de transmission disposé à l'extérieur de la cavité résonante, un faisceau de retour d'ordre zéro transmis par l'intermédiaire du premier réseau de transmission ;
  mesurer un déplacement d'une position associée au faisceau de surveillance par rapport à une position d'alignement ; et
  commander une configuration physique sur la base du déplacement mesuré, la configuration physique étant celle du miroir résonateur commandable et/ou du premier réseau de transmission.

2.  Procédé selon la revendication 1, dans lequel :

  le miroir résonateur commandable a une position le long d'une direction du faisceau de retour ;
  un plan laser est défini par le faisceau de retour et le faisceau de retour diffracté ;
  la mesure du déplacement consiste à : mesurer un déplacement dans le plan laser de la position associée au faisceau de surveillance par rapport à la position d'alignement ; et
  la commande de la configuration physique consiste à : commander la position du miroir commandable le long de la direction du faisceau de retour ou de la position du premier réseau de transmission dans le plan laser pour aligner un mode de cavité d'un laser du système laser accordable avec un spectre de filtrage associé au premier réseau de transmission et au miroir résonateur commandable.

3.  Procédé selon la revendication 1, dans lequel :

  un plan laser est défini par le faisceau de retour et le faisceau de retour diffracté ;
  le miroir du résonateur commandable présente un angle d'inclinaison par rapport au plan laser ;
  la mesure du déplacement consiste à : mesurer un déplacement hors du plan laser de la position associée au faisceau de surveillance depuis la position d'alignement ; et
  la commande de la configuration physique consiste à : commander l'angle d'inclinaison du miroir résonateur sur la base du déplacement mesuré hors du plan laser afin d'aligner le faisceau de retour diffracté avec le milieu à gain dans une direction normale au plan laser.

4.  Procédé selon l'une quelconque des revendications 1 à 3, consistant en outre à :

  focaliser le faisceau de surveillance sur un détecteur sensible à la position, la position associée au faisceau de surveillance étant une position du faisceau de surveillance focalisé sur le détecteur sensible à la position ; ou
  focaliser le faisceau de surveillance et utiliser un miroir de balayage pour balayer le faisceau de surveillance focalisé sur une zone contenant un récepteur de petite surface, la position associée au faisceau de surveillance correspondant à une orientation du miroir de balayage lorsque le faisceau de surveillance focalisé est incident sur le récepteur de petite surface ; ou
  focaliser le faisceau de surveillance et balayer le récepteur de petite surface sur une zone coupée par le faisceau de surveillance focalisé, la position associée au faisceau de surveillance correspondant à une position du récepteur de petite surface à l'intérieur de la zone balayée lorsque le faisceau de surveillance focalisé est incident sur le récepteur de petite surface.

5.  Système laser accordable, comprenant :

  un premier miroir résonateur et un second miroir résonateur, les premier et second miroirs résonateurs formant une cavité de résonance, le premier miroir résonateur étant commandable ;
  un milieu à gain disposé à l'intérieur de la cavité résonante ;
  un premier réseau de transmission à mode sélectif disposé à l'intérieur de la cavité résonante entre le milieu à gain et le miroir résonateur commandable, le premier réseau de transmission étant configuré pour générer, à partir d'un faisceau de retour reçu en provenance du miroir résonateur commandable, un faisceau de retour diffracté et un faisceau de retour d'ordre zéro ;
  un second réseau de transmission disposé à l'extérieur de la cavité résonante sur un trajet du faisceau de retour d'ordre zéro, le second réseau de transmission étant configuré pour diffracter le faisceau de retour d'ordre zéro afin de générer un faisceau de surveillance ;
  un sous-système de surveillance de position configuré pour mesurer un déplacement d'une position associée au faisceau de surveillance par rapport à une position d'alignement ; et
  un dispositif de commande configuré pour commander une configuration physique sur la base du déplacement mesuré, la configuration physique étant celle du miroir résonateur commandable et/ou du premier réseau de transmission.

6.  Système laser accordable selon la revendication 5, dans lequel la configuration physique comprend au moins un paramètre sélectionné dans le groupe comprenant : une position du miroir résonateur commandable le long d'une direction du faisceau de retour, une position du premier réseau de transmission dans un plan laser défini par le faisceau de retour et le faisceau de retour diffracté, et un angle d'inclinaison du miroir résonateur commandable par rapport au plan laser.

7. Système laser accordable selon la revendication 6, dans lequel :

le sous-système de surveillance de position est configuré pour mesurer le déplacement en mesurant un déplacement dans le plan laser de la position associée au faisceau de surveillance par rapport à la position d'alignement ; et le dispositif de commande est configuré pour commander la configuration physique en commandant la position du miroir commandable le long de la direction du faisceau de retour ou de la position du premier réseau de transmission dans le plan laser pour aligner un mode de cavité d'un laser du système laser accordable avec un spectre de filtrage associé au premier réseau de transmission et au miroir résonateur commandable.

8. Système laser accordable selon la revendication 6, dans lequel :

le dispositif de commande est en outre configuré pour : accorder une position de longueur d'onde d'un spectre de filtrage associé au premier réseau de transmission et au miroir résonateur commandable en réglant une orientation du miroir résonateur commandable dans le plan laser ; le sous-système de surveillance de position est configuré pour mesurer le déplacement dans le plan laser en mesurant le déplacement dans le plan laser sur une plage d'accord de la position de longueur d'onde du spectre de filtrage ; et le dispositif de commande est en outre configuré pour commander, pendant l'accord du spectre de filtrage, la position du miroir résonateur commandable le long de la direction du faisceau de retour ou la position du premier réseau de transmission dans le plan laser sur la base du déplacement dans le plan laser mesuré, pour une position de longueur d'onde instantanée du spectre de filtrage, afin d'obtenir un accord de longueur d'onde sans saut de mode.

9. Système laser accordable selon la revendication 8, dans lequel :

le sous-système de surveillance de position est configuré pour mesurer le déplacement dans le plan laser pendant l'accord du spectre de filtrage ; et le dispositif de commande est configuré pour commander la position du miroir résonateur commandable en commandant dans une boucle d'asservissement.

10. Système laser accordable selon la revendication 6, dans lequel :

le sous-système de surveillance de position est configuré pour mesurer le déplacement en mesurant un déplacement hors du plan laser de la position associée au faisceau de surveillance depuis la position d'alignement ; et le dispositif de commande est configuré pour commander la configuration physique en commandant l'angle d'inclinaison du miroir résonateur sur la base du déplacement mesuré hors du plan laser afin d'aligner le faisceau de retour diffracté avec le milieu à gain dans une direction normale au plan laser.

11. Système laser accordable selon la revendication 6, dans lequel :

le sous-système de surveillance de position est configuré pour mesurer le déplacement en mesurant le déplacement à la fois dans le plan laser et hors du plan laser ; et le dispositif de commande est configuré pour commander la configuration physique en commandant la position du miroir résonateur commandable le long de la direction du faisceau de retour ou de la position du premier réseau de transmission dans le plan laser et en commandant l'angle d'inclinaison du miroir commandable.

12. Système laser accordable selon la revendication 6, dans lequel le dispositif de commande est en outre configuré pour :

créer, sur la base de la position associée au faisceau de surveillance et d'une puissance de sortie d'un laser du système laser sur une plage de positions et sur une plage d'angles d'inclinaison du miroir résonateur, une correspondance entre la position associée au faisceau de surveillance et la puissance de sortie, la plage de positions étant du miroir résonateur commandable le long de la direction du faisceau de retour ou du premier réseau de transmission dans le plan laser ; et déterminer la position d'alignement sur la base de la correspondance.

**13.** Système laser accordable selon l'une quelconque des revendications 5 à 12, comprenant en outre :

une première optique de focalisation, disposée à l'intérieur de la cavité résonnante, afin de focaliser le faisceau de retour diffracté sur le milieu à gain ; et

une seconde optique de focalisation, disposée à l'extérieur de la cavité résonante, afin de focaliser le faisceau de surveillance, une longueur focale de la seconde optique de focalisation étant supérieure à une longueur focale de la première optique de focalisation.

**14.** Système laser accordable selon la revendication 5, dans lequel le sous-système de surveillance de position comprend :

un détecteur sensible à la position disposé sur un trajet du faisceau de surveillance, la position associée au faisceau de surveillance correspondant à une position du faisceau de surveillance sur le détecteur sensible à la position ;

un récepteur de petite surface et un dispositif de balayage de faisceau, le dispositif de balayage de faisceau étant configuré pour balayer le faisceau de surveillance sur une zone contenant le récepteur de petite surface, la position associée au faisceau de surveillance correspondant à une orientation du dispositif de balayage de faisceau lorsque le faisceau de surveillance est incident sur le récepteur de petite surface ; ou

un récepteur mobile de petite surface et un mécanisme d'actionnement configuré pour déplacer le récepteur de petite surface sur une zone coupée par le faisceau de surveillance, la position associée au faisceau de surveillance correspondant à une position du récepteur mobile de petite surface lorsque le faisceau de surveillance est incident sur le récepteur mobile de petite surface ;

un récepteur de petite surface configuré pour recevoir la lumière incidente en provenance du faisceau de surveillance, le récepteur de petite surface comprenant un photodétecteur ou une face d'entrée d'une fibre optique couplée à un photodétecteur au niveau d'une extrémité de sortie de la fibre optique.

**15.** Support lisible par machine comprenant une pluralité d'instructions lisibles par machine qui, lorsqu'elles sont exécutées par un ou plusieurs processeurs associés à un système laser accordable comprenant un premier réseau de transmission à mode sélectif disposé dans une cavité résonnante entre un milieu à gain et un miroir résonateur commandable, amènent le ou les processeurs à réaliser le procédé selon l'une quelconque des revendications 1 à 4.

FIG. 1

FIG. 2A

FIG. 2B

FIG. 3A

FIG. 3B

FIG. 4A

FIG. 4B

FIG. 4C

FIG. 5A

FIG. 5B

FIG. 6

FIG. 7A

FIG. 7B

**FIG. 8**

**FIG. 9**

FIG. 10

FIG. 11A

FIG. 11B

**FIG. 12**

24

FIG. 13

EP 4 162 571 B1

FIG. 14

FIG. 15A

FIG. 15B

1602 — Create monitoring beam outside the laser cavity

1604 — Measure a position associated with the monitoring beam and an output power of the laser to determine an alignment position

1606 — Measure displacement of a position associated with monitoring beam relative to the alignment position

1608 — Control physical configuration of the controllable resonator mirror and/or the transmission grating based on the displacement to align laser beam to gain medium in-plane and/or out-of-plane

FIG. 16

1700 ⟍

**1702** ⟍
Create monitoring beam outside the laser cavity

**1704** ⟍
Sweep laser wavelength by tuning cavity mode and filter spectrum with controllable mirror and/or transmission grating

**1706** ⟍
Measure displacement in the laser plane of a position associated with the monitoring beam relative to an alignment position

**1708** ⟍
Characterize laser sweep in terms of displacement

**1710** ⟍
Adjust tuning or controllable mirror and/or transmission grating based on the displacement characterization to align cavity mode with filter spectrum

FIG. 17

**EP 4 162 571 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2009185586 A1